(19) Europäisches Patentamt / European Patent Office / Office européen des brevets

(11) **EP 2 661 167 B1**

(12) **EUROPEAN PATENT SPECIFICATION**

(45) Date of publication and mention
of the grant of the patent:
**02.01.2019 Bulletin 2019/01**

(21) Application number: **11854440.2**

(22) Date of filing: **01.11.2011**

(51) Int Cl.:
*H05K 9/00* $^{(2006.01)}$     *H01Q 17/00* $^{(2006.01)}$

(86) International application number:
**PCT/JP2011/075183**

(87) International publication number:
**WO 2012/090586 (05.07.2012 Gazette 2012/27)**

(54) **NEAR-FIELD ELECTROMAGNETIC WAVE ABSORBER**

NAHFELD-ABSORBER FÜR ELEKTROMAGNETISCHE WELLEN

ABSORBEUR D'ONDES ÉLECTROMAGNÉTIQUES DE CHAMP PROCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2010 JP 2010290703**

(43) Date of publication of application:
**06.11.2013 Bulletin 2013/45**

(73) Proprietor: **Kagawa, Seiji**
**Saitama 343-0807 (JP)**

(72) Inventor: **Kagawa, Seiji**
**Saitama 343-0807 (JP)**

(74) Representative: **Diehl & Partner GbR**
**Patentanwälte**
**Erika-Mann-Strasse 9**
**80636 München (DE)**

(56) References cited:
**WO-A1-2009/157544     WO-A1-2010/093027**
**JP-A- 2009 176 827     JP-A- 2010 278 090**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to a near-field electromagnetic wave absorber having high absorbability of electromagnetic wave noises of several hundreds of MHz to several GHz, with reduced anisotropy.

BACKGROUND OF THE INVENTION

To prevent malfunctions by electromagnetic wave noises emitted from various communications apparatuses and electronic appliances, etc., various electromagnetic wave absorbers have been put into practical use. Because a magnetic field is predominant in a near field (a magnetic field component is stronger), electromagnetic wave absorbers comprising magnetic materials have conventionally been used widely. Electromagnetic wave absorbers comprising conductive powders were also proposed.

For example, JP 2007-96269 A discloses a near-field electromagnetic wave absorber having a layer of conductive materials such as carbon nano-fibers, carbon nano-tubes, etc. formed on a non-metal substrate such as a paper, a plastic film, etc. However, this near-field electromagnetic wave absorber has an insufficient transmission attenuation power ratio Rtp, about 10 dB at most, and the anisotropy of electromagnetic wave absorbability is not considered at all.

JP 2006-279912 A discloses a sputtered thin film of AlO, CoAlO, CoSiO, etc., as a thin film for suppressing near-field electromagnetic wave noises, which has a reflection coefficient ($S_{11}$) of -10 dB or less to electromagnetic wave noises generated in a semi-microwave band, and surface resistance controlled to 10-1000 $\Omega$/square to match a free space characteristic impedance Z (377 $\Omega$) to obtain a noise reduction effect ($\Delta P_{loss}/P_{in}$) of 0.5 or more. However, this thin film for suppressing near-field electromagnetic wave noises does not have sufficient electromagnetic wave absorbability, and the anisotropy of electromagnetic wave absorbability is not considered at all.

JP 2008-533 83 A discloses a radiowave-absorbing and shielding film having excellent heat dissipation characteristics, which comprises a graphite film having different thermal conductivities in a plane direction and a thickness direction, and a soft-magnetic layer formed thereon, which contains soft-magnetic materials such as Fe, Co, FeSi, FeNi, FeCo, FeSiAl, FeCrSi, FeBSiC, etc., ferrite such as Mn-Zn ferrite, Ba-Fe ferrite, Ni-Zn ferrite, etc., and carbon particles. However, this radiowave-absorbing and shielding film has an insufficient attenuation ratio of 10 dB or less, and the anisotropy of electromagnetic wave absorbability is not considered at all.

Document WO 2010/093027 A1 by the present applicant discloses a metal thin film-plastic film composite with linear streaks suitable for an electromagnetic wave absorbing material. The streaks have irregular widths and are interrupted and parallel with each other, while being arranged in plural directions at irregular intervals.

OBJECT OF THE INVENTION

Accordingly, an object of the present invention is to provide a near-field electromagnetic wave absorber having high absorbability of electromagnetic wave noises of several hundreds of MHz to several GHz, with reduced anisotropy.

SUMMARY OF THE INVENTION

As a result of intensive research in view of the above object, the inventor has found that in a near-field electromagnetic wave absorber formed by adhering pluralities of electromagnetic-wave-absorbing films each having a thin metal film formed on a surface of a plastic film, the absorbability of near-field electromagnetic waves is extremely improved by (a) constituting the thin metal film of at least one electromagnetic-wave-absorbing film by a thin film layer of a magnetic metal, and (b) forming a large number of substantially parallel, intermittent linear scratches in plural directions with irregular widths and irregular intervals on the thin metal film of at least one electromagnetic-wave-absorbing film. The present invention has been completed based on such finding.

Thus, the near-field electromagnetic wave absorber of the present invention is formed by adhering pluralities of electromagnetic-wave-absorbing films each having a thin metal film formed on a surface of a plastic film, the thin metal film of at least one electromagnetic-wave-absorbing film having a thin film layer of a magnetic metal, and a large number of substantially parallel, intermittent linear scratches being formed in plural directions with irregular widths and irregular intervals on the thin metal film of at least one electromagnetic-wave-absorbing film.

Adjacent electromagnetic-wave-absorbing films are preferably adhered with their thin metal films facing each other. With a sufficiently thin adhesive layer, the facing thin metal films are electromagnetically coupled via an adhesive layer.

The linear scratches are preferably formed in plural directions on the thin metal films of all electromagnetic-wave-absorbing films. The thin metal film of each electromagnetic-wave-absorbing film preferably has surface resistance in a range of 50-1500 $\Omega$/square after the linear scratches are formed. The surface resistance of the thin metal film can be adjusted by linear scratches.

The magnetic metal is preferably nickel. The thin metal film of at least one electromagnetic-wave-absorbing film preferably comprises a thin conductive metal film layer and a thin magnetic metal film layer. All thin metal films more preferably comprise a thin conductive metal film layer and a thin magnetic metal film layer.

The linear scratches are preferably oriented in two directions with a crossing angle of 30-90°. The linear scratches preferably have widths, 90% or more of which are in a range of 0.1-100 $\mu$m, an average width of 1-50 $\mu$m, intervals in a range of 0.1-200 $\mu$m, and an average interval of 1-100 $\mu$m.

BRIEF DESCRIPTION OF THE DRAWINGS

Fig. 1 is a cross-sectional view showing an electromagnetic-wave-absorbing film having a thin metal film with linear scratches.

Fig. 2 is a partial plan view showing an example of linear scratches.

Fig. 3(a) is a partial plan view showing another example of linear scratches.

Fig. 3(b) is a partial plan view showing a further example of linear scratches.

Fig. 3(c) is a partial plan view showing a still further example of linear scratches.

Fig. 4(a) is a perspective view showing an example of apparatuses for producing an electromagnetic-wave-absorbing film.

Fig. 4(b) is a plan view showing the apparatus of Fig. 4(a).

Fig. 4(c) is a cross-sectional view taken along the line B-B in Fig. 4(b).

Fig. 4(d) is a partial, enlarged plan view for explaining the principle of forming linear scratches inclined to the moving direction of the film.

Fig. 4(e) is a partial plan view showing the inclination angles of a pattern roll and a push roll to a film in the apparatus of Fig. 4(a).

Fig. 5 is a partial cross-sectional view showing another example of apparatuses for producing an electromagnetic-wave-absorbing film.

Fig. 6 is a perspective view showing a further example of apparatuses for producing an electromagnetic-wave-absorbing film.

Fig. 7 is a perspective view showing a still further example of apparatuses for producing an electromagnetic-wave-absorbing film.

Fig. 8 is a perspective view showing a still further example of apparatuses for producing an electromagnetic-wave-absorbing film.

Fig. 9(a) is a cross-sectional view showing an example of the near-field electromagnetic wave absorbers of the present invention.

Fig. 9(b) is an exploded cross-sectional view showing the near-field electromagnetic wave absorber of Fig. 9(a).

Fig. 10(a) is a cross-sectional view showing another example of the near-field electromagnetic wave absorbers.

Fig. 10(b) is an exploded cross-sectional view showing the near-field electromagnetic wave absorber of Fig. 10(a).

Fig. 11(a) is an exploded perspective view showing an example of combinations of electromagnetic-wave-absorbing films in the near-field electromagnetic wave absorber.

Fig. 11(b) is an exploded perspective view showing another example of combinations of electromagnetic-wave-absorbing films in the near-field electromagnetic wave absorber.

Fig. 12(a) is an exploded plan view showing an example of combinations of two electromagnetic-wave-absorbing films having linear scratches in the near-field electromagnetic wave absorber.

Fig. 12(b) is an exploded plan view showing another example of combinations of two electromagnetic-wave-absorbing films having linear scratches in the near-field electromagnetic wave absorber.

Fig. 12(c) is an exploded plan view showing a further example of combinations of two electromagnetic-wave-absorbing films having linear scratches in the near-field electromagnetic wave absorber.

Fig. 13(a) is a plan view showing a system for evaluating the electromagnetic wave absorbability of a near-field electromagnetic wave absorber.

Fig. 13(b) is a cross-sectional view showing a system for evaluating the electromagnetic wave absorbability of a near-field electromagnetic wave absorber.

Fig. 14 is a graph showing $R_{tp}$, $S_{11}$ and $S_{12}$ of the near-field electromagnetic wave absorber of Example 1.

Fig. 15 is a graph showing $R_{tp}$, $S_{11}$ and $S_{12}$ of the near-field electromagnetic wave absorber of Example 2.

Fig. 16 is a graph showing $R_{tp}$, $S_{11}$ and $S_{12}$ of the near-field electromagnetic wave absorber of Comparative Example 1.

Fig. 17 is a graph showing $R_{tp}$, $S_{11}$ and $S_{12}$ of the near-field electromagnetic wave absorber of Comparative Example 2.

DESCRIPTION OF THE PREFERRED EMBODIMENTS

The embodiments of the present invention will be explained referring to the attached drawings, and it should be noted that explanation concerning one embodiment is applicable to other embodiments unless otherwise mentioned. Also, the following explanation is not restrictive, and various modifications may be made within the scope of the present invention.

[1] Electromagnetic-wave-absorbing film

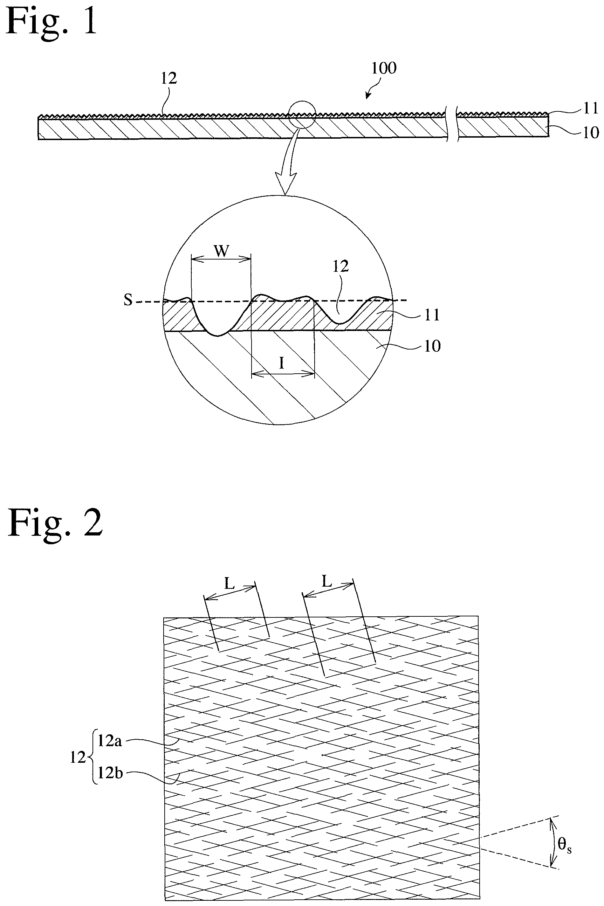

A first electromagnetic-wave-absorbing film 100 constituting the near-field electromagnetic wave absorber comprises a thin metal film 11 formed on a surface of a plastic film 10, the thin metal film 11 being provided with linear scratches 12 in plural directions as shown in Fig. 1.

(1) Plastic film

Resins forming the plastic film 10 are not particularly restrictive as long as they have sufficient strength, heat resistance, flexibility and workability in addition to insulation, and they may be, for instance, polyesters (polyethylene terephthalate, etc.), polyarylene sulfide (polyphenylene sulfide, etc.), polyether sulfone, polyetheretherketone, polycarbonates, acrylic resins, polystyrenes, polyolefins (polyethylene, polypropylene, etc.), etc. The thickness of the plastic film 10 may be about 10-100 $\mu$m.

(2) Thin metal film

The thin metal film 11 is made of a conductive metal or a magnetic metal, and the thin metal film of at least one electromagnetic-wave-absorbing film should have a thin film layer of a magnetic metal. Conductive metals include copper, aluminum, silver, etc., and magnetic metals include nickel, chromium, etc. These metals are not restricted to pure metals but may be alloys. The thin metal film 11 can be formed by known methods such as a sputtering method, a vacuum vapor deposition method, etc.

The thickness of the thin metal film is preferably 5-200 nm, more preferably 10-100 nm, most preferably 10-50 nm, when the linear scratches are not formed. When the linear scratches are formed, the thickness of the thin metal film 11 is 0.01-1 $\mu$m. The thin metal film 11 may be a laminate of a conductive metal and a magnetic metal. A preferred combination of the conductive metal and the magnetic metal is copper and nickel. The thickness of the thin conductive metal film is preferably 0.01-1 $\mu$m, and the thickness of the thin magnetic metal film is preferably 5-200 $\mu$m. When the linear scratches are not formed, the surface resistance of the thin metal film 11 is preferably 50-1500 $\Omega$/square, more preferably 100-1000 $\Omega$/square, most preferably 200-1000 $\Omega$/square. The surface resistance can be measured by a DC two-terminal method.

(2) Linear scratches

To exhibit excellent electromagnetic wave absorbability while suppressing its anisotropy, the thin metal film 11 of at least one electromagnetic-wave-absorbing film should be provided with substantially parallel, intermittent, linear scratches 12 with irregular widths and irregular intervals in plural directions. Fig. 2 shows an example of pluralities of linear scratches 12. A large number of substantially parallel, intermittent, linear scratches 12a, 12b are oriented in plural directions (in two directions in the depicted example) with irregular widths and irregular intervals. The depth of the linear scratches 12 is exaggerated in Fig. 1 for the purpose of explanation. The linear scratches 12 oriented in two directions have various widths W and intervals I. The term "intervals I" means intervals in both of orientation directions (longitudinal directions) and their perpendicular directions (transverse directions) of the linear scratches 12. The widths W and intervals I of the linear scratches 12 are measured at a height (original height) corresponding to the surface S of the thin metal film 11 before forming linear scratches.

Because the linear scratches 12 have various widths W and intervals I, the electromagnetic-wave-absorbing film 1 can efficiently absorb electromagnetic waves in a wide frequency range.

90% or more of the widths W of the linear scratches 12 are preferably in a range of 0.1-100 $\mu$m, more preferably in a range of 0.1-50 $\mu$m, most preferably in a range of 0.1-20 $\mu$m. The average width Wav of the linear scratches 12 is preferably 1-50 $\mu$m, more preferably 1-20 $\mu$m, most preferably 1-10 $\mu$m.

The intervals I of the linear scratches 12 are preferably in a range of 0.1-200 $\mu$m, more preferably in a range of 0.1-100 μm, most preferably in a range of 0.1-50 μm, particularly in a range of 0.1-20 μm. The average interval lav of the linear scratches 12 is preferably 1-100 μm, more preferably 1-50 μm, most preferably 1-20 μm.

Because the lengths L of the linear scratches 12 are determined by sliding conditions (mainly relative peripheral speeds of a roll and a film, and the angle of the film winding around the roll), they are substantially the same unless the sliding conditions are changed (substantially equal to the average length). The lengths of the linear scratches 12 may be practically about 1-100 mm, though not particularly restrictive.

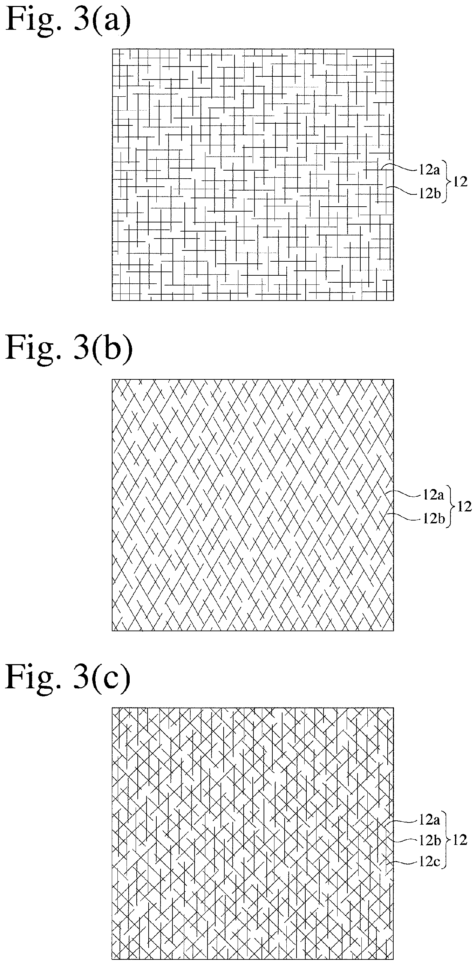

The acute crossing angle (hereinafter referred to simply as "crossing angle" unless otherwise mentioned) $\theta$s of the linear scratches 12a, 12b in two directions are preferably 30-90°, more preferably 45-90°, most preferably 60-90°. With sliding conditions (sliding direction, peripheral speed ratio, etc.) between the plastic film 10 and the pattern roll adjusted, linear scratches 12 with various crossing angles $\theta$s can be formed as shown in Figs. 3(a) to 3(c). The orientations of the linear scratches are not restricted to two directions but may be three directions or more. Linear scratches 12 in Fig. 3(a) are constituted by linear scratches 12a, 12b perpendicular to each other, linear scratches 12 in Fig. 3(b) are constituted by linear scratches 12a, 12b crossing at 60°, and linear scratches 12 in Fig. 3(c) are constituted by linear scratches 12a, 12b, 12c in three directions. The surface resistance of the thin metal film 11, which is formed with relatively large thickness, is adjacent to preferably 50-1500 Ω/square, more preferably 100-1000 Ω/square, most preferably 200-1000 Ω/square, by the formation of linear scratches.

(3) Protective layer

When pluralities of electromagnetic-wave-absorbing films are adhered with a thin metal film 11 exposed outside, a protective layer (not shown) is preferably formed on the exposed surface of the thin metal film 11. The protective layer is preferably a hard coat or film of plastics. When a film is used, it is preferably adhered by a heat lamination method or a dry lamination method. The hard coat of plastics can be formed, for example, by applying a photo-curing resin or the irradiation of ultraviolet rays. The thickness of each protective layer 13 is preferably about 10-100 μm.

[2] Apparatus for forming linear scratches

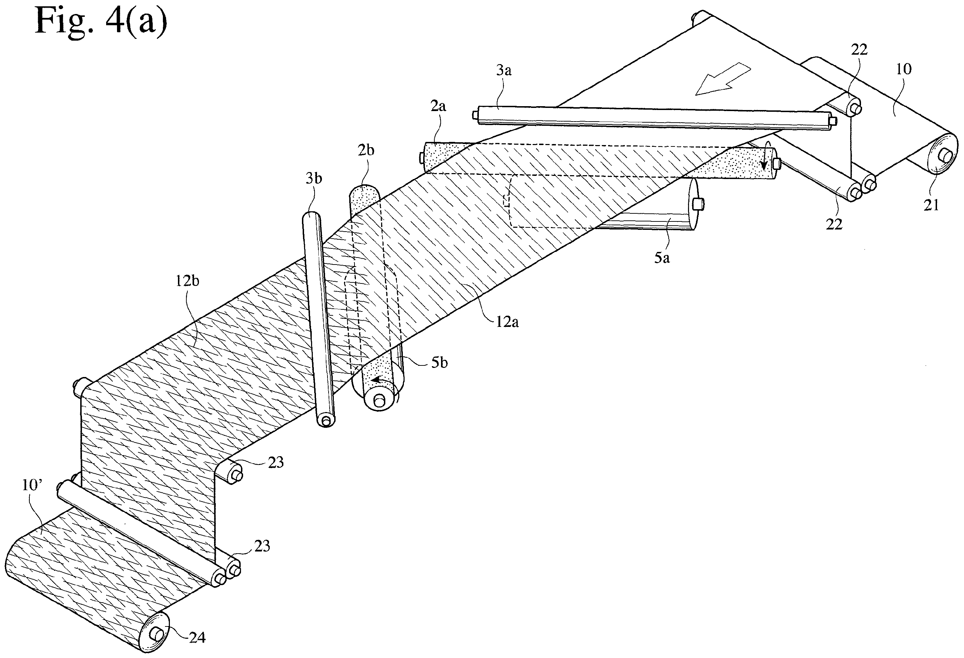

Figs. 4(a)-4(e) show one example of apparatuses for forming linear scratches in two directions on a plastic film. For the simplification of explanation, a method for forming linear scratches will be explained, taking an example a case where linear scratches are simply formed on a plastic film 10, but the method is of course applicable to the formation of linear scratches on a thin metal film 11 as it is.

The depicted apparatus comprises (a) a reel 21 from which a plastic film 10 is wound off, (b) a first pattern roll 2a arranged in a different direction from the transverse direction of the plastic film 10 on the side of the thin metal film 11, (c) a first push roll 3a arranged upstream of the first pattern roll 2a on the opposite side, (d) a second pattern roll 2b arranged in an opposite direction to the first pattern roll 2a with respect to the transverse direction of the plastic film 10 on the same side as the first pattern roll 2a, (e) a second push roll 3b arranged downstream of the second pattern roll 2b on the opposite side thereto, and (f) a reel 24, around which the plastic film 10' with linear scratches is wound. In addition, pluralities of guide rolls 22, 23 are arranged at predetermined positions. Each pattern roll 2a, 2b is supported by a backup roll (for instance, rubber roll) 5a, 5b to prevent bending.

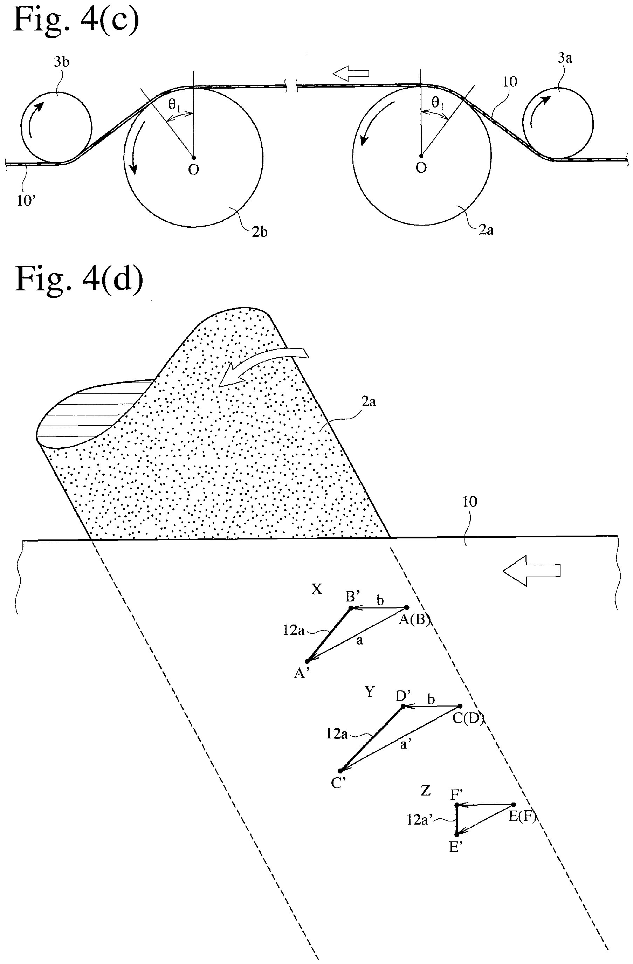

As shown in Fig. 4(c), because the plastic film 10 comes into contact with each push roll 3a, 3b at a lower position than its sliding contact position with each pattern roll 2a, 2b, the plastic film 10 is pushed by each pattern roll 2a, 2b. By adjusting the height of each push roll 3a, 3b with this condition met, the pressing power of each pattern roll 2a, 2b to the plastic film 10 can be controlled, and the sliding distance in proportion to a center angle $\theta_1$ can also be controlled.

Fig. 4(d) shows the principle that linear scratches 12a are formed on the plastic film 10 with inclination to the moving direction thereof. Because the pattern roll 2a is inclined to the moving direction of the plastic film 10, the moving direction (rotation direction) of fine, hard particles on the pattern roll 2a differs from the moving direction of the plastic film 10. After a fine, hard particle on a point A on the pattern roll 2a comes into contact with the plastic film 10 to form a scratch B at an arbitrary time as shown by X, the fine, hard particle moves to a point A', and the scratch B moves to a point B', in a predetermined period of time. While the fine, hard particle moves from the point A to the point A', the scratch is continuously formed, resulting in a linear scratch 12a extending from the point A' to the point B'.

The directions and crossing angle $\theta$s of linear scratch groups 12a, 12b formed by the first and second pattern rolls 2a, 2b can be adjusted by changing the angle of each pattern roll 2a, 2b to the plastic film 10, and/or the peripheral speed of each pattern roll 2a, 2b relative to the moving speed of the plastic film 10. For instance, when the peripheral speed $a$ of the pattern roll 2a relative to the moving speed b of the plastic film 10 increases, the linear scratches 12a can be inclined 45° to the moving direction of the plastic film 10 like a line C'D' as shown by Y in Fig. 4(d). Similarly, the peripheral speed $a$ of the pattern roll 2a can be changed by changing the inclination angle $\theta_2$ of the pattern roll 2a to the transverse direction of the plastic film 10. This is true of the pattern roll 2b. Accordingly, with both pattern rolls 2a, 2b adjusted, the directions of the linear scratches 12a, 12b can be changed.

Because each pattern roll 2a, 2b is inclined to the plastic film 10, sliding contact with each pattern roll 2a, 2b provides the plastic film 10 with a force in a transverse direction. Accordingly, to prevent the lateral movement of the plastic film 10, the height and/or angle of each push roll 3a, 3b to each pattern roll 2a, 2b are preferably adjusted. For instance, the proper adjustment of a crossing angle $\theta_3$ between the axis of the pattern roll 2a and the axis of the push roll 3a provides pressing power with such a transverse direction distribution as to cancel transverse components, thereby preventing the lateral movement. The adjustment of a distance between the pattern roll 2a and the push roll 3a also contributes to the prevention of the lateral movement. To prevent the lateral movement and breakage of the plastic film 10, the rotation directions of the first and second pattern rolls 2a, 2b inclined to the transverse direction of the plastic film 10 are preferably the same as the moving direction of the plastic film 10.

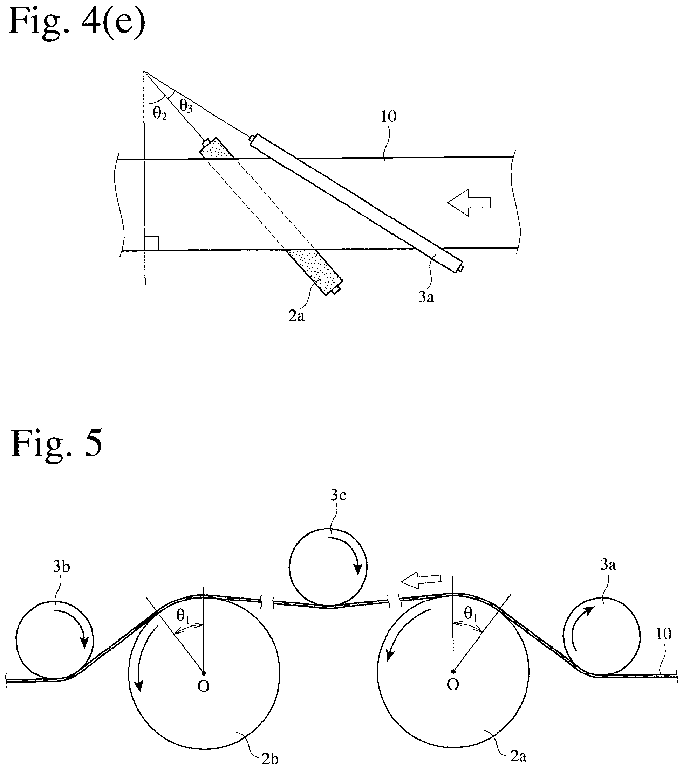

To increase the power of the pattern rolls 2a, 2b pressing the plastic film 10, a third push roll 3c may be provided between the pattern rolls 2a, 2b as shown in Fig. 5. The third push roll 3c increases the sliding distance of the plastic film 10 proportional to the center angle $\theta_1$, resulting in longer linear scratches 12a, 12b. The adjustment of the position and inclination angle of the third push roll 3c contributes to the prevention of the lateral movement of the plastic film 10.

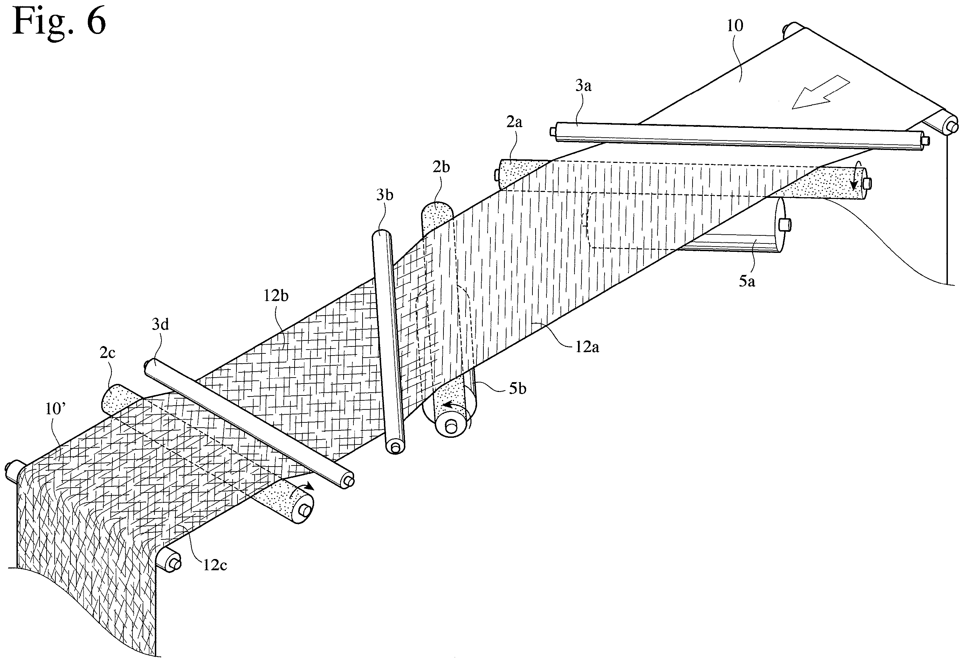

Fig. 6 shows an example of apparatuses for forming linear scratches oriented in three directions as shown in Fig. 3(c). This apparatus is different from the apparatus shown in Figs. 4(a) to 4(e) in that it comprises a third pattern roll 2c parallel to the transverse direction of the plastic film 10 downstream of the second pattern roll 2b. Though the rotation direction of the third pattern roll 2c may be the same as or opposite to the moving direction of the plastic film 10, it is preferably an opposite direction to form linear scratches efficiently. The third pattern roll 2c parallel to the transverse direction forms linear scratches 12c aligned with the moving direction of the plastic film 10. Though the third push roll 3d is arranged upstream of the third pattern roll 2c, it may be on the downstream side. Not restricted to the depicted examples, the third pattern roll 2c may be arranged upstream of the first pattern roll 2a, or between the first and second pattern rolls 2a, 2b.

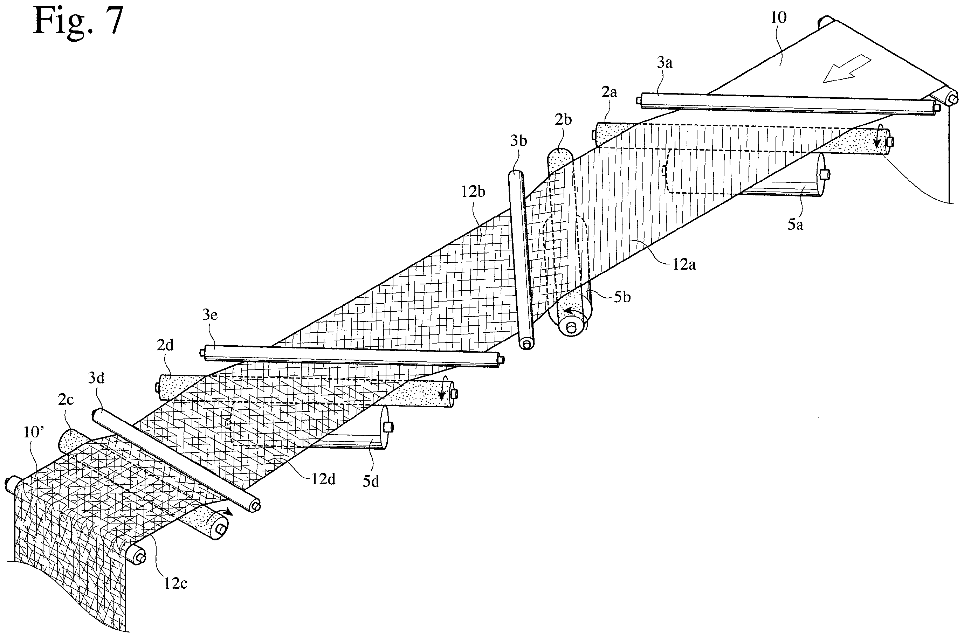

Fig. 7 shows one example of apparatuses for forming linear scratches oriented in four directions. This apparatus is different from the apparatus shown in Fig. 6, in that it comprises a fourth pattern roll 2d between the second pattern roll 2b and the third pattern roll 2c, and a fourth push roll 3e upstream of the fourth pattern roll 2d. With a slower rotation speed of the fourth pattern roll 2d, the direction (line E'F') of linear scratches 12a' can be made in parallel to the transverse direction of the plastic film 10 as shown by Z in Fig. 4(d).

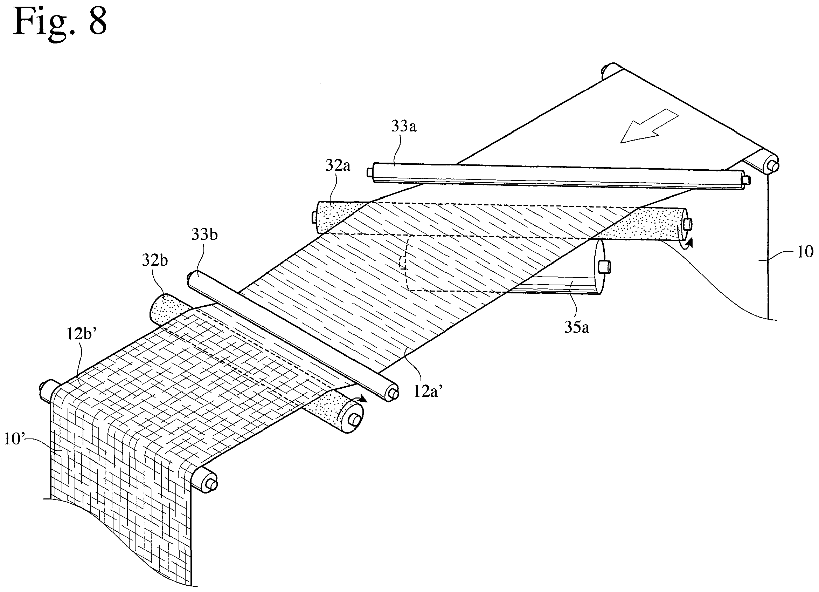

Fig. 8 shows another example of apparatuses for forming linear scratches crossing perpendicularly as shown in Fig. 3(a). This apparatus is different from the apparatus shown in Figs. 4(a) to 4(e), in that a second pattern roll 32b is arranged in parallel to the transverse direction of the plastic film 10. Accordingly, explanation will be made below only on different portions from those shown in Figs. 4(a) to 4(e). The rotation direction of the second pattern roll 32b may be the same as or opposite to the moving direction of the plastic film 10. Also, the second push roll 33b may be upstream or downstream of the second pattern roll 32b. This apparatus makes the direction (line E'F') of linear scratches 12a' in alignment with the transverse direction of the film 10 as shown by Z in Fig. 4(d), suitable for forming linear scratches crossing perpendicularly.

Operation conditions determining not only the inclination angles and crossing angles of linear scratches but also their depths, widths, lengths and intervals are the moving speed of the plastic film 10, the rotation speeds, inclination angles and pressing powers of the pattern rolls, etc. The moving speed of the film is preferably 5-200 m/minute, and the peripheral speed of the pattern roll is preferably 10-2,000 m/minute. The inclination angles $\theta_2$ of the pattern rolls are preferably 20°-60°, particularly about 45°. The tension (in parallel to the pressing power) of the film 10 is preferably 0.05-5 kgf/cm width.

The pattern roll is preferably a roll having fine particles with sharp edges and Mohs hardness of 5 or more on the surface, for instance, the diamond roll described in JP 2002-59487 A. Because the widths of linear scratches are determined by the sizes of fine particles, 90% or more of fine diamond particles preferably have sizes in a range of 1-100 $\mu$m, more preferably in a range of 10-50 $\mu$m. The fine diamond particles are attached to the roll surface preferably in an area ratio of 30% or more.

[3] Near-field electromagnetic wave absorber

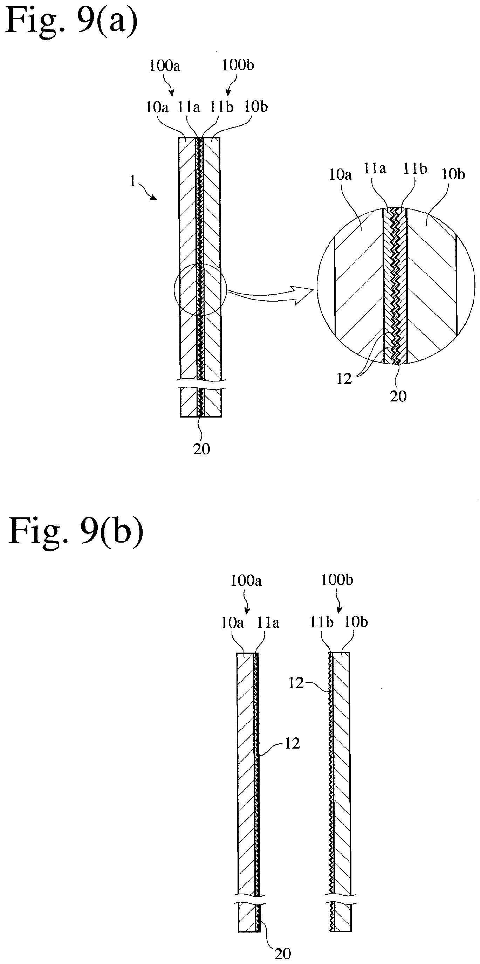

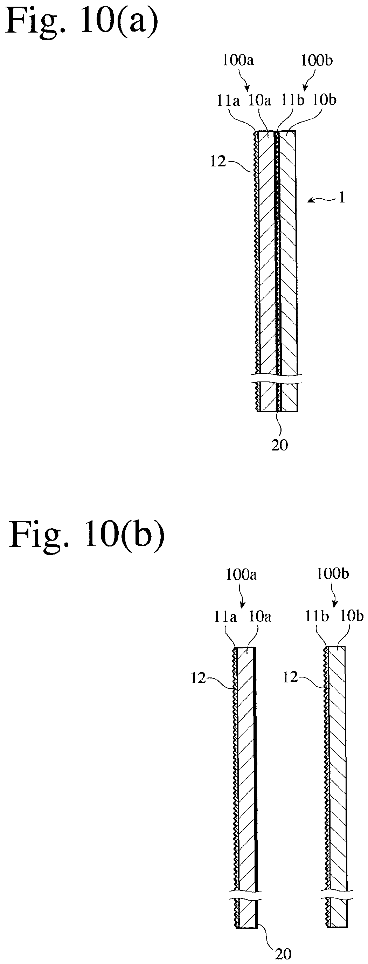

The near-field electromagnetic wave absorber of the present invention is obtained by laminating pluralities of electromagnetic-wave-absorbing films via an adhesive layer. Two electromagnetic-wave-absorbing films 100a, 100b are adhered with thin metal films 11a, 11b facing each other in the example shown in Fig. 9, and thin metal films 11a, 11b facing the same side are adhered in the example shown in Fig. 10.

In the near-field electromagnetic wave absorber shown in Fig. 9, which has a layer structure of a first electromagnetic-wave-absorbing film 100a, an adhesive layer 20 and a second electromagnetic-wave-absorbing film 100b, with thin metal films 11a, 11b opposing via the adhesive layer 20, the thin metal films 11a and 11b can be electromagnetically coupled by an extremely thin adhesive layer 20. Accordingly, linear scratches 12a, 12b formed on the thin metal film 11a and linear scratches 12a, 12b formed on the thin metal film 11b preferably have different crossing angles θs. For example, when linear scratches 12a, 12b formed on the thin metal film 11a have a crossing angle θs of 90°, linear scratches 12a, 12b formed on the thin metal film 11b preferably have a crossing angle θs of 60°, 45° or 30°. This near-field electromagnetic wave absorber is obtained by forming an adhesive layer 20 on one thin metal film 11a, 11b, and then bonding both electromagnetic-wave-absorbing films 100a, 100b by an adhesive as shown in Fig. 9(b). To obtain sufficient electromagnetic coupling between the thin metal films 11a and 11b, the thickness of the adhesive layer 20 is 5 μm or less. Because the near-field electromagnetic wave absorber shown in Fig. 9 has plastic films outside, protective layers for the thin metal films 11a, 11b are advantageously unnecessary.

As shown in Figs. 10(a) and 10(b), thin metal films 11a, 11b in two electromagnetic-wave-absorbing films 100a, 100b may be in the same direction. In this case, too, the thin metal films 11a, 11b are electromagnetically coupled via the plastic film 10a and the adhesive layer 20 to a smaller extent, resulting in a slightly poorer effect of suppressing electromagnetic wave noises than in the example shown in Fig. 9.

At least one of the thin metal film 11a in the first electromagnetic-wave-absorbing film 100a and the thin metal film 11b in the second electromagnetic-wave-absorbing film 100b should have a thin magnetic metal film layer. For example, when the thin metal film 11a is made of aluminum, the thin metal film 11b is made of nickel or a composite film having a thin nickel film layer (for example, copper/nickel composite film). Of course, both thin metal films 11a, 11b may be thin magnetic metal films, but at least one of thin metal films 11a, 11b preferably has a thin conductive metal film layer. Accordingly, preferred combinations of the thin metal films 11a, 11b are (a) a combination of a thin aluminum film layer and a thin nickel film layer, (b) a combination of a thin copper film layer and a thin nickel film layer, (c) a combination of a thin copper film layer and a thin copper film layer/thin nickel film layer, (d) a combination of a thin copper film layer/thin nickel film layer and a thin copper film layer/thin nickel film layer, etc. Because large electromagnetic wave absorbability is obtained when both thin metal films 11a, 11b have a thin conductive metal film layer and a thin magnetic metal film layer, the combination (d) is most preferable.

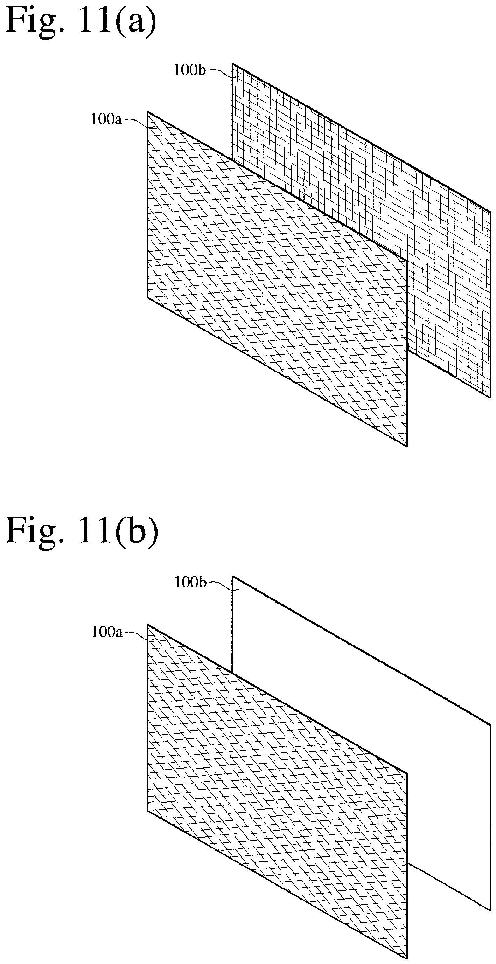

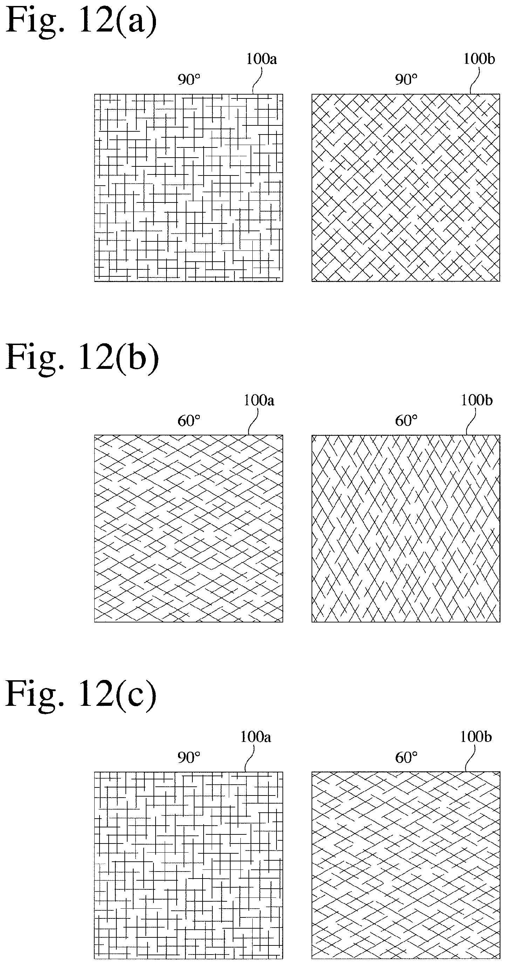

at least one of thin metal films 11a, 11b is provided with linear scratches 12 in plural directions, but it is more preferable that all thin metal films 11a, 11b are provided with linear scratches 12 in plural directions. Fig. 11(a) shows an example in which linear scratches 12 are formed on the thin metal films 11a, 11b in both electromagnetic-wave-absorbing films 100a, 100b, and Fig. 11(b) shows an example in which linear scratches 12 are formed on the thin metal film 11a, 11b in one of the electromagnetic-wave-absorbing films 100a, 100b. As shown in Figs. 12(a)-12(c), the anisotropy of electromagnetic wave absorbability is reduced by changing the orientations and crossing angles θs of linear scratches in two electromagnetic-wave-absorbing films 100a, 100b, resulting in excellent electromagnetic wave absorbability. Though the crossing angles θs of linear scratches are 60° and 90° in the exemplified electromagnetic-wave-absorbing films 100a, 100b, the present invention is of course not restricted thereto, but other crossing angles θs within 30-90° are usable.

The present invention will be explained in more detail referring to Examples below without intention of restricting it thereto.

Example 1

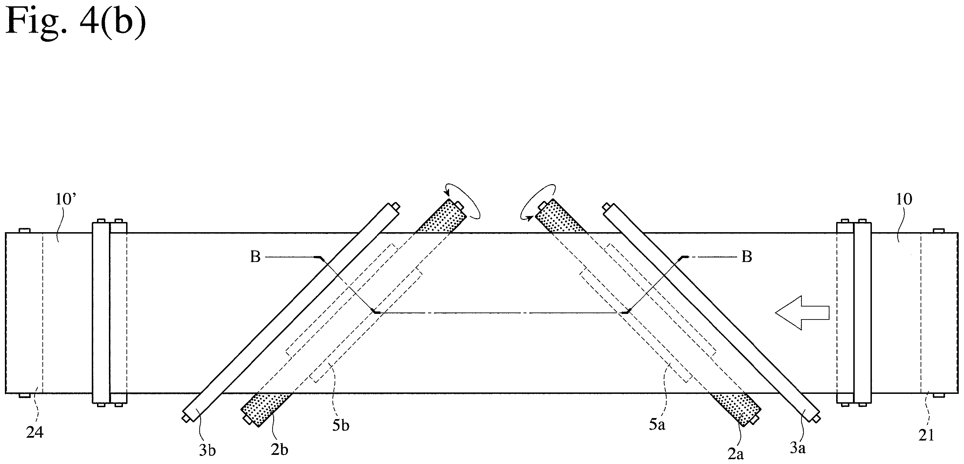

A thin Cu film layer having a thickness of 0.7 μm and a thin Ni film layer having a thickness of 50 nm were successively formed on a 16-μm-thick PET film 10a, to form a thin metal film 11a. Using an apparatus having the structure shown in Fig. 8, which comprised pattern rolls 32a, 32b having electroplated fine diamond particles having a particle size distribution of 50-80 μm, linear scratches in two directions (crossing angle: 90°) were formed on the thin metal film 11a to obtain an electromagnetic-wave-absorbing film 100a. Likewise, a thin metal film 11b comprising a thin Cu film layer having a thickness of 0.7 μm and a thin Ni film layer having a thickness of 50 nm was formed on a 16-μm-thick PET film 10b, and linear scratches in two directions (crossing angle: 60°) were formed on the thin metal film 11b by the apparatus shown in Fig. 4 to obtain an electromagnetic-wave-absorbing film 100b. The characteristics of linear scratches in each electromagnetic-wave-absorbing film 100a, 100b were as follows:

| | |
|---|---|
| Range of widths W | 0.5-5 μm, |
| Average width Wav | 2 μm, |
| Range of transverse intervals I | 2-30 μm, |
| Average transverse interval Iav | 10 μm, |
| Average length Lav | 5 mm, and |
| Crossing angle θs | 90° and 60°. |

The electromagnetic-wave-absorbing films 100a, 100b with linear scratches were adhered to each other by a commercially available adhesive with the thin metal films 11a, 11b inside, to produce a test piece TP (55.2 mm x 4.7 mm) of a near-field electromagnetic wave absorber 1 shown in Fig. 9(a). The thickness of an adhesive layer 20 was about 1 $\mu$m.

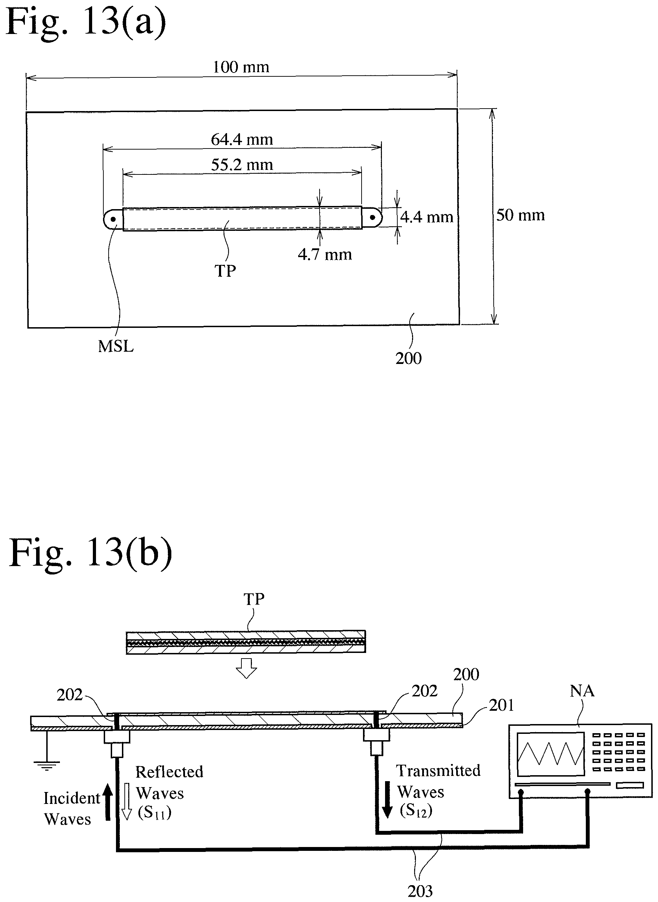

Using a near-field electromagnetic wave evaluation system shown in Fig. 13, which comprised a 50-$\Omega$ micro-stripline MSL (64.4 mm x 4.4 mm), an insulating substrate 200 supporting the microstripline MSL, a grounded electrode 201 attached to a lower surface of the insulating substrate 200, conductive pins 202, 202 connected to both ends of the microstripline MSL, a network analyzer NA, and coaxial cables 203, 203 connecting the network analyzer NA to the conductive pins 202, 202, reflected wave power $S_{11}$ and transmitting wave power $S_{12}$ to incident waves of 0-6 GHz were measured on the test piece TP attached to the microstripline MSL by an adhesive, and a transmission attenuation power ratio $R_{tp}$ was determined by the following formula:

$$R_{tp} = -10 \times \log[10^{S21/10}/(1-10^{S11/10})].$$

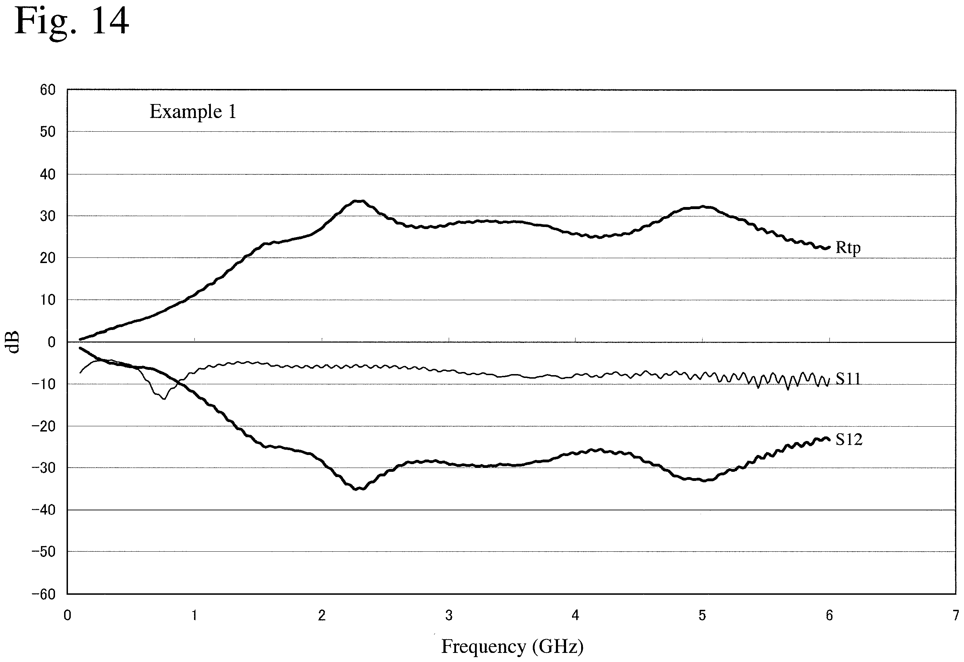

The results are shown in Fig. 14. As is clear from Fig. 14, the transmission attenuation power ratio $R_{tp}$ was as large as 20 dB or more in a wide range of about 1.5-6 GHz.

By the same evaluation conducted on a test piece cut out of this electromagnetic wave absorber 1 in a direction perpendicular to the above test piece TP, a transmission attenuation power ratio $R_{tp}$ substantially on the same level was obtained. This indicates that the electromagnetic wave absorber 1 of Example 1 had small anisotropy in electromagnetic wave absorbability.

Example 2

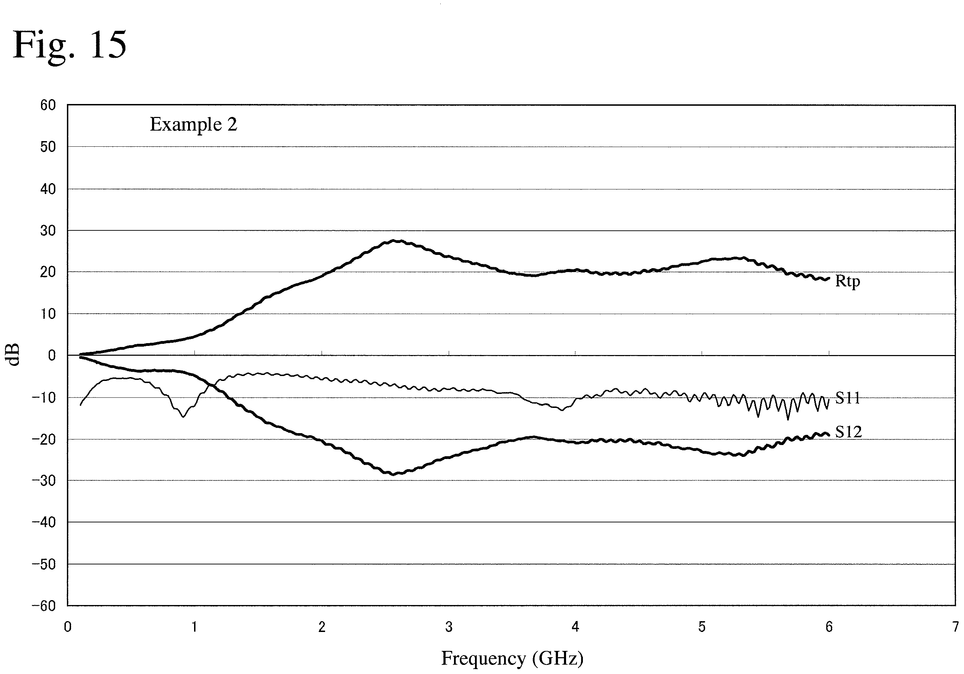

A near-field electromagnetic wave absorber 1 was produced in the same manner as in Example 1, except that the electromagnetic-wave-absorbing films 100a, 100b were adhered with a 16-$\mu$m-thick PET film interposed between the thin metal films 11a and 11b, and the reflected wave power $S_{11}$ and the transmitting wave power $S_{12}$ were measured to determine a transmission attenuation power ratio $R_{tp}$. The results are shown in Fig. 15. As is clear from Fig. 15, the transmission attenuation power ratio $R_{tp}$ was as large as 20 dB or more in a wide range of about 2-5.7 GHz, though slightly lower than that of Example 1. This indicates that electromagnetic wave absorbability is affected by the electromagnetic coupling of the thin metal films 11a and 11b.

Comparative Example 1

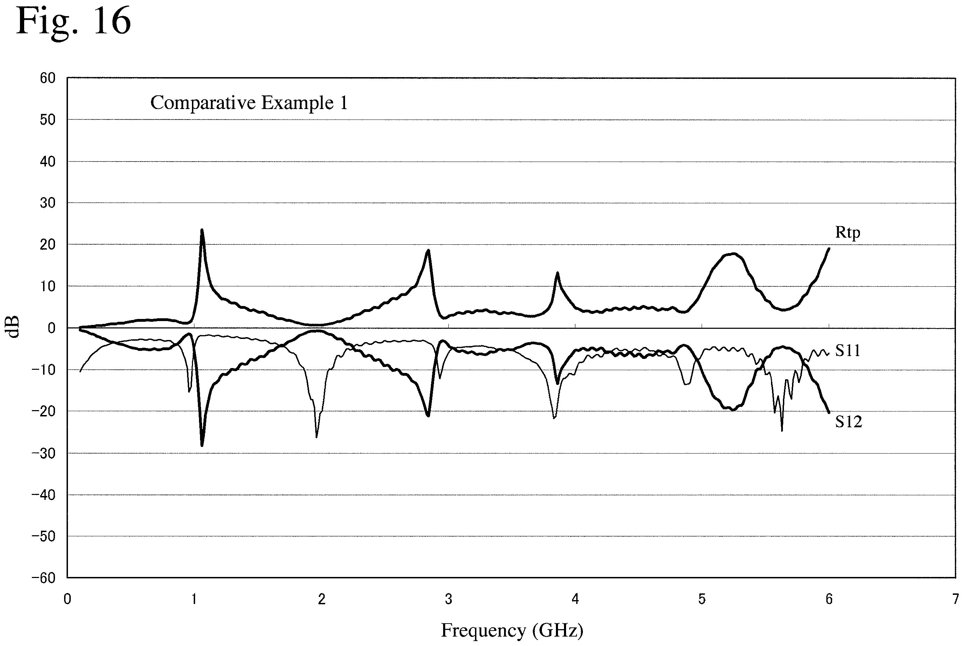

A near-field electromagnetic wave absorber 1 was produced in the same manner as in Example 1 except for forming no linear scratches, and the reflected wave power $S_{11}$ and the transmitting wave power $S_{12}$ were measured to determine a transmission attenuation power ratio $R_{tp}$. The results are shown in Fig. 16. As is clear from Fig. 16, the transmission attenuation power ratio $R_{tp}$ was small in a frequency range of 0-6 GHz. This indicates that even an near-field electromagnetic wave absorber constituted by two electromagnetic-wave-absorbing films each having a thin metal film comprising a thin conductive metal film layer and a thin magnetic metal film layer had extremely low electromagnetic wave absorbability, without linear scratches on both thin metal films.

Comparative Example 2

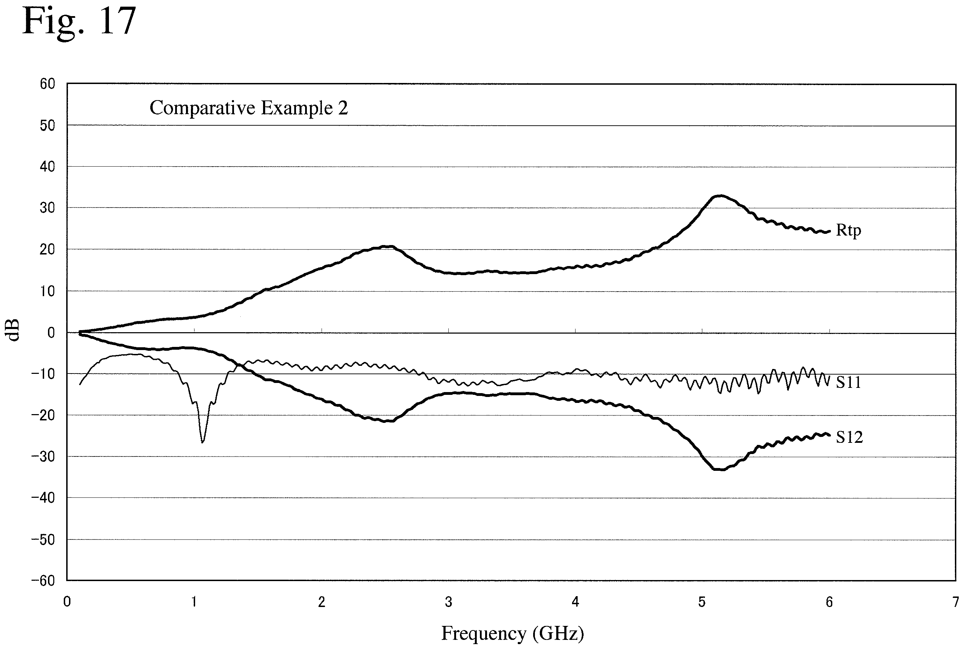

The reflected wave power $S_{11}$ and transmitting wave power $S_{12}$ of the electromagnetic-wave-absorbing film 100a produced in Example 1, which had linear scratches in two directions (crossing angle: 90°) formed on a thin metal film 11a comprising a thin Cu film layer having a thickness of 0.7 $\mu$m and a thin Ni film layer having a thickness of 50 nm, were measured in the same manner as in Example 1, to determine a transmission attenuation power ratio $R_{tp}$. The results are shown in Fig. 17. As is clear from Fig. 17, $R_{tp}$ of more than 20 dB was obtained only in a frequency range of about 4.5 GHz or more, extremely narrower than in Examples 1 and 2.

The structures of the near-field electromagnetic wave absorbers of Examples and Comparative Examples are summarized in Table 1 below.

Table 1

| No. | Fig. | Layer Structure |
|---|---|---|
| Example 1 | 9(a) | PET/Cu/Ni (linear scratches having crossing angle of 90°) + adhesive layer + Ni/Cu/PET (linear scratches having crossing angle of 60°) |

(continued)

| No. | Fig. | Layer Structure |
|---|---|---|
| Example 2 | - | PET/Cu/Ni (linear scratches having crossing angle of 90°) + adhesive layer + PET + adhesive layer + Ni/Cu/PET (linear scratches having crossing angle of 60°) |
| Comparative Example 1 | - | PET/Cu/Ni (no linear scratches) + adhesive layer + Ni/Cu/PET (no linear scratches) |
| Comparative Example 2 | 1 | PET/Cu/Ni (linear scratches having crossing angle of 90°) |

EFFECTS OF THE INVENTION

The near-field electromagnetic wave absorber of the present invention having the above structure has high absorbability of electromagnetic wave noises of several hundreds of MHz to several GHz, with reduced anisotropy. The near-field electromagnetic wave absorber of the present invention having such feature is effective for suppressing electromagnetic wave noises in various electronic appliances and communications apparatuses such as personal computers, cell phones, smartphones, etc.

**Claims**

1.  A near-field electromagnetic wave absorber (1) formed by adhering pluralities of electromagnetic-wave-absorbing films (100a, 100b) each having a thin metal film (11a, 11b) having a thickness of 0.01-1 $\mu$m and formed on a surface of a plastic film (10a, 10b),

    (a) said near-field electromagnetic wave absorber (1) comprising a first electromagnetic-wave-absorbing film (100a) provided with a first thin metal film (11a) comprising a thin magnetic metal film layer and a thin conductive metal film layer, and a second electromagnetic-wave-absorbing film (100b) provided with a second thin metal film (11b) comprising a thin magnetic metal film layer and a thin conductive metal film layer;
    (b) a large number of parallel, intermittent linear scratches (12) being formed in plural directions with irregular widths and irregular intervals on each of said first and second thin metal films (11a, 11b); and
    (c) the crossing angle of the linear scratches (12) formed on said first thin metal film (11a) being different from the crossing angle of the linear scratches (12) formed on said second thin metal film (11b);
    **characterized in that**
    (d) said first and second electromagnetic-wave-absorbing films (100a, 100b) are adhered, such that said first and second thin metal films (11a, 11b) are facing each other via an adhesive layer (20), said adhesive layer (20) having a thickness of 5 $\mu$m or less, such that the facing thin metal films (11a, 11b) are electromagnetically coupled via the adhesive layer (20).

2.  The near-field electromagnetic wave absorber (1) according to claim 1, wherein the thin metal film (11a, 11b) of each electromagnetic-wave-absorbing film (100a, 100b) has surface resistance in a range of 50 to 1500 $\Omega$/square after the linear scratches (12) are formed.

3.  The near-field electromagnetic wave absorber (1) according to any one of claims 1 to 2, wherein said magnetic metal is nickel.

4.  The near-field electromagnetic wave absorber (1) according to any one of claims 1 to 3, wherein said linear scratches (12) are oriented in two directions with a crossing angle of 30 to 90°.

5.  The near-field electromagnetic wave absorber (1) according to any one of claims 1 to 4, wherein said linear scratches (12) have widths, 90% or more of which are in a range of 0.1 to 100 $\mu$m, an average width of 1 to 50 $\mu$m, intervals in a range of 0.1 to 200 $\mu$m, and an average interval of 1 to 100 $\mu$m.

**Patentansprüche**

1.  Absorber (1) für elektromagnetische Wellen im Nahfeld, gebildet durch Aneinanderheften mehrerer elektromagnetische Wellen absorbierender Folien (100a, 100b), die jeweils eine dünne Metallfolie (11a, 11b) mit einer Dicke von 0,01 bis 1 μm aufweisen und auf der Oberfläche einer Plastikfolie (10a, 10b) gebildet sind, wobei

(a) der Absorber (1) für elektromagnetische Wellen im Nahfeld eine erste elektromagnetische Wellen absorbierende Folie (100a) aufweist, die eine erste dünne Metallfolie (11a) mit einer dünnen magnetischen Metallfolienschicht und einer dünnen leitfähigen Metallfolienschicht aufweist, und eine zweite elektromagnetische Wellen absorbierende Folie (100b) aufweist, die eine zweite dünne Metallfolie (11b) mit einer dünnen magnetischen Metallfolienschicht und einer dünnen leitfähigen Metallfolienschicht aufweist;

(b) eine große Anzahl von parallelen, unterbrochenen linearen Ritzungen (12), die in mehreren Richtungen mit uneinheitlichen Breiten und in uneinheitlichen Abständen auf sowohl der ersten als auch der zweiten dünnen Metallfolie (11a, 11b) gebildet sind; und

(c) der Schnittwinkel der auf der ersten dünnen Metallfolie (11a) gebildeten linearen Ritzungen (12) von dem Schnittwinkel der auf der zweiten dünnen Metallfolie (11b) gebildeten linearen Ritzungen (12) abweicht; **dadurch gekennzeichnet, dass**

(d) die erste und die zweite elektromagnetische Wellen absorbierende Folie (100a, 100b) derart aneinander geheftet sind, dass die erste und die zweite Metallfolie (11a, 11b) einander über eine Klebeschicht (20) gegenüberliegen, wobei die Klebeschicht (20) eine Dicke von 5 μm oder weniger aufweist, so dass die einander zugewandten dünnen Metallfolien (11a, 11b) über die Klebeschicht (20) hinweg elektromagnetisch miteinander gekoppelt sind.

2. Absorber (1) für elektromagnetische Wellen im Nahfeld gemäß Anspruch 1, wobei die dünne Metallfolie (11a, 11b) jeder der elektromagnetische Wellen absorbierenden Folien (100a, 100b) einen Oberflächenwiderstand in einem Bereich von 50 bis 1500 Ω/Quadrat aufweist, nachdem die linearen Ritzungen (12) gebildet worden sind.

3. Absorber (1) für elektromagnetische Wellen im Nahfeld gemäß einem der Ansprüche 1 bis 2, wobei das magnetische Metall Nickel ist.

4. Absorber (1) für elektromagnetische Wellen im Nahfeld gemäß einem der Ansprüche 1 bis 3, wobei die linearen Ritzungen (12) in zwei Richtungen unter einem Schnittwinkel von 30 bis 90° angeordnet sind.

5. Absorber (1) für elektromagnetische Wellen im Nahfeld gemäß einem der Ansprüche 1 bis 4, wobei die linearen Ritzungen (12) Breiten aufweisen, von denen 90% oder mehr in einem Bereich von 0,1 bis 100 μm liegen, mit einer durchschnittlichen Breite von 1 bis 50 μm, Intervallen in einem Bereich von 0,1 bis 200 μm, und einem durchschnittlichen Intervall von 1 bis 100 μm.

## Revendications

1. Absorbeur d'ondes électromagnétiques en champ proche (1) formé en faisant adhérer des plurali-tés de films absorbeurs d'ondes électromagnétiques (100a, 100b) ayant chacun un film de métal mince (11a, 11b) ayant une épaisseur de 0,01 à 1 μ m et formés sur une surface d'un film plastique (10a, 10b),

(a) ledit absorbeur d'ondes électromagné-tiques en champ proche (1) comprenant un premier film absorbeur d'ondes électromagnétiques (100a) pourvu d'un premier film de métal mince (11a) comprenant une couche de film de métal magnétique mince et une couche de film de métal conducteur mince, et un second film absorbeur d'ondes électromagnétiques (100b) pourvu d'un second film de métal mince (11b) comprenant une couche de film de métal magnétique mince et une couche de film de métal conducteur mince,

(b) un grand nombre de rayures linéaires in-termittentes parallèles (12) étant formées dans une pluralité de directions avec des largeurs irrégulières et des intervalles irréguliers sur chacun desdits pre-mier et second films de métal minces (11a, 11b) ; et

(c) l'angle de croisement des rayures li-néaires (12) formées sur ledit premier film de métal mince (11a) étant différent de l'angle de croisement des rayures linéaires (12) formées sur ledit second film de métal mince (11b) ; caractérisé en ce

(d) lesdits premier et second films absor-beurs d'ondes électromagnétiques (100a, 100b) adhè-rent, de telle sorte que lesdits premier et second films de métal minces (11a, 11b) sont en regard l'un de l'autre via une couche adhésive (20), ladite couche adhésive (20) ayant une épaisseur de 5 μ m ou moins, de telle sorte que les films de métal minces opposés (11a, 11b) soient couplés électromagnétiquement via la couche adhésive (20).

2. Absorbeur d'ondes électromagnétiques en champ proche (1) selon la revendication 1, dans lequel le film de métal mince (11a, 11b) de chaque film absorbeur d'ondes électromagnétiques (100a, 100b) a une résistance superficielle dans une plage de 50 à 1 500 Q/carré après que les rayures linéaires (12) sont formées.

3. Absorbeur d'ondes électromagnétiques en champ proche (1) selon l'une quelconque des revendica-tions 1 à 2, dans lequel ledit métal magnétique est du nickel.

4. Absorbeur d'ondes électromagnétiques en champ proche (1) selon l'une quelconque des revendica-tions 1 à 3, dans lequel lesdites rayures linéaires (12) sont orientées dans deux directions avec un angle de croisement de 30 à 90°.

5. Absorbeur d'ondes électromagnétiques en champ proche (1) selon l'une quelconque des revendica-tions 1 à 4, dans lequel lesdites rayures linéaires (12) ont des largeurs, dont 90 % ou plus sont dans une plage de 0,1 à 100 $\mu$m, une largeur moyenne de 1 à 50 $\mu$m, des intervalles dans une plage de 0,1 à 200 $\mu$m, et un intervalle moyen de 1 à 100 $\mu$ m.

# Fig. 1

# Fig. 2

## Fig. 3(a)

## Fig. 3(b)

## Fig. 3(c)

# Fig. 4(a)

EP 2 661 167 B1

Fig. 4(b)

15

# Fig. 4(c)

# Fig. 4(d)

# Fig. 4(e)

# Fig. 5

# Fig. 6

Fig. 7

EP 2 661 167 B1

# Fig. 8

# Fig. 9(a)

# Fig. 9(b)

# Fig. 10(a)

100a　　100b

11a　10a　11b　10b

12

1

20

# Fig. 10(b)

100a　　　　100b

11a　10a　　11b　10b

12　　　　12

20

Fig. 11(a)

Fig. 11(b)

## Fig. 12(a)

90°  100a  90°  100b

## Fig. 12(b)

60°  100a  60°  100b

## Fig. 12(c)

90°  100a  60°  100b

# Fig. 13(a)

# Fig. 13(b)

# Fig. 14

EP 2 661 167 B1

# Fig. 15

EP 2 661 167 B1

Fig. 16

# Fig. 17

EP 2 661 167 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007096269 A
- JP 2006279912 A
- JP 2008053383 A
- WO 2010093027 A1
- JP 2002059487 A